(19) Europäisches Patentamt / European Patent Office / Office européen des brevets

(11) **EP 4 455 785 A1**

(12) **EUROPEAN PATENT APPLICATION**

(43) Date of publication:
**30.10.2024 Bulletin 2024/44**

(21) Application number: **23169762.4**

(22) Date of filing: **25.04.2023**

(51) International Patent Classification (IPC):
**G03F 7/00** (2006.01)    **G02B 7/182** (2021.01)

(52) Cooperative Patent Classification (CPC):
**G03F 7/70258; G02B 7/1827; G03F 7/70825; G03F 7/7085**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventor: **BUTLER, Hans**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD AND SYSTEM TO CONTROL THE POSITION OF AN OPTICAL ELEMENT**

(57)    The present disclosure provides a method of controlling a position of an optical element for projecting an image, the method comprising the steps of: - providing the optical element having at least one actuator to allow movement of the optical element in at least a first degree of freedom and at least a second degree of freedom; - determining a movement error of the optical element in at least the second degree of freedom; - correcting an image projection error caused by the movement error in the second degree of freedom using a movement of the optical element in the first degree of freedom.

FIG. 4

**Description**

FIELD

The present invention relates to a method and system to control the position of an optical element. The optical element may be a mirror included in a lithographic apparatus using extreme ultraviolet light (EUV) to irradiate a pattern onto a substrate. The position on the optical element may be controlled to control the position of an image projected using the optical element.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Lithography apparatuses typically comprise a number of optical components, such as lenses or mirrors. In an EUV machine, the optical components typically include mirrors.

The position of optical components can typically be adapted within a specified, multidimensional travel path, such as in six degrees of freedom. Thus, movement of respective optical components can be used to correct potential deformations of the substrate or mask due to, for instance, impact of the radiation. Said impact may for instance result in heat dissipation in the substrate, leading to thermal stresses in the substrate and corresponding deformation. As the heat dissipation and resulting deformation can be predicted, the position of respective optical elements can be adjusted accordingly to keep irradiating a predetermined location on the substrate even when the substrate deforms during the process.

A position of one or more of the optical components may be actively controlled using, for example, a number of Lorentz actuators. A problem with this method however may occur due to nonlinearity in actuators controlling the position of an optical element.

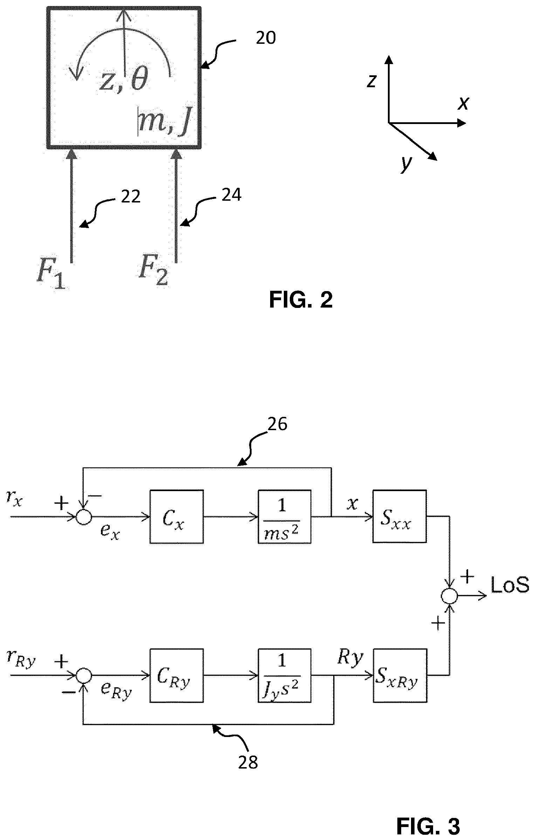

Generally referring to Figure 2, an optical element 20 may typically be provided with two linear actuators 22, 24 per linear degree of freedom, with each actuator working in the same direction. To achieve six degrees of freedom, a respective optical element may be provided with six linear actuators, with pairs of two linear actuators for each axis. Herein, three perpendicular axes x, y, z, may mutually define three dimensions.

Herein, both linear actuators provide a force $F_1$, $F_2$ acting in the same direction. For a translation in said direction, for instance along the z-axis, both actuators 22, 24 provide a similar translation. For a rotation $\theta$ around an axis of rotation perpendicular to said z-axis, for instance a rotation around the x-axis or y-axis, both actuators 22, 24 provide a different translation or force along the z-axis.

However, the actuator gains and linearity are imperfect. The gains are expected to drift over time and depending on operating conditions, and to be position dependent. When moving laterally in, for instance, a first direction, both actuators need to provide the same force. Although relatively small, even a state of the art actuator may still have a margin of error in the order of, for instance, 0.25%. Due to the actuator gain inaccuracy, the forces $F_1$, $F_2$ applied by both actuators 22, 24 in said first direction are not equal, and hence a disturbance torque occurs that leads to a rotation of the respective optical element. Since the inertia $J$ of the optical element is typically about 30 to 100 times smaller than the mass $m$ of the optical element 20, the effective rotational disturbance is relatively large. The rotational disturbance of the optical element results in a relatively large line-of-sight error of the image position on the substrate. Line-of-sight herein refers to the predetermined location of an image projected on the substrate. To optimize accuracy of the lithographic process, it is highly desirable to minimize the line-of-sight error.

US20210026252A1 provides a method for localizing an abnormality in a travel path of an optical component in or for a lithography apparatus. The method includes: a) moving the optical component in at least one first degree of freedom; b) detecting a movement (Rz) of the optical component and/or a force acting on the optical component in at least one second degree of freedom; and c) localizing the abnormality as a function of the movement detected in b) and/or the force detected in b). The concept underlying the method involves drawing conclusions about an abnormality in the first degree of freedom by observing a second degree of freedom (which is a degree of freedom different from the first degree of freedom) of the optical component. As a result, a corresponding abnormality can be rapidly localized, thereby reducing outage times of the lithography apparatus.

The method of US20210026252A1 is concerned with preventing collision of the optical element with a hardware boundary, to avoid damage to the optical element. The method is however unsuitable, or at least is insufficiently accurate, to correct the line-of-sight error as described above.

The present disclosure aims to provide an improved method and system to correct a line-of-sight error due to actuator errors of an optical component.

## SUMMARY

The present disclosure provides a method of controlling a position of an optical element for projecting an image, the method comprising the steps of:

- providing the optical element having at least one actuator to allow movement of the optical element in at least a first degree of freedom and at least a second degree of freedom;
- determining a movement error of the optical element in at least the second degree of freedom;
- correcting an image projection error caused by the movement error in the second degree of freedom using a movement of the optical element in the first degree of freedom.

In an embodiment, the step of determining a movement error of the optical element comprises determining a movement error in six degrees of freedom.

In an embodiment, the step of determining a movement error of the optical element includes obtaining said error from a controller of the number of actuators.

The method may comprise the step of deriving the image projection error from the movement error of the optical element.

In an embodiment, the image projection error equals the optical sensitivities of the optical element, which are provided as a reference.

The step of correcting the image projection error may comprise providing a correction factor to the first degree of freedom, the correction factor including a multiplier based on the optical sensitivities.

In an embodiment, the correction factor for the first degree of freedom comprises a ratio of an optical sensitivity with regard to the second degree of freedom ($S_{DOF2}$) to the optical sensitivity with regards to the first degree of freedom ($S_{DOF1}$).

In an embodiment, the correction factor from the second degree of freedom to the first degree of freedom can be expressed including the multiplier $K = S_{DOF2} / S_{DOF1}$.

In an embodiment, the first degree of freedom is a translational degree freedom, and the second degree of freedom is a rotational degree of freedom.

In an embodiment, the method comprises the steps of:

- allowing the number of actuators to move the optical element in at least six degrees of freedom, comprising three translational degrees of freedom and three rotational degrees of freedom;
- controlling movement of the optical element in two or more of the at least six degrees of freedom using respective correction factors based on the optical sensitivities.

In an embodiment, the method comprises the step of using the optical element for projecting a patterned beam of radiation onto a substrate while controlling the position of the optical element.

According to another aspect, the disclosure provides a system to control the position of an optical element for projecting an image, comprising:

- at least one actuator for moving the optical element in at least a first degree of freedom and at least a second degree of freedom;
- means to determine a movement error of the optical element in the second degree of freedom;
- a correction mechanism to correct an image projection error caused by the movement error in the second degree of freedom using a movement of the optical element in the first degree of freedom.

In an embodiment, the system comprises a controller for controlling movement of the at least one actuator, the controller being adapted to provide one or more optical sensitivities of the optical element.

In an embodiment, the correction mechanism is adapted to correct the image projection error by providing a correction factor to the first degree of freedom, the correction factor including a multiplier based on the projection sensitivities.

In an embodiment, the correction factor for the first degree of freedom comprises a ratio of an optical sensitivity with regard to the second degree of freedom (SDOF2) to the optical sensitivity with regard to the first degree of freedom (SDOF1).

The at least one actuator may be adapted to move the optical element in at least six degrees of freedom, comprising three translational degrees of freedom and three rotational degrees of freedom; and

the controller may be adapted for controlling movement of the optical element in two or more of the at least six degrees of freedom using respective correction factors based on the projection sensitivities.

According to another aspect, the disclosure provides a lithographic system comprising:

- at least one radiation source for providing radiation;
- at least one substrate table for holding a substrate;
- at least one optical element for directing the radiation towards the substrate; and
- a control system adapted to control the position of the at least one optical element, the control system being adapted to correct an image projection error caused by a movement error in a second degree of freedom using a movement of the optical element in the first degree of freedom.

The lithographic system may comprise at least one system as described above.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 depicts a schematic representation of an optical element provided with two linear actuators to provide translation in one direction ($r_z$) and/or rotation in a perpendicular direction ($\theta_x$ or $r_{Rx}$);
- Figure 3 depicts an exemplary control diagram indicating a line-of-sight (LoS) error resulting from error in translation and/or rotation of one or more optical elements;
- Figure 4 schematically depicts a diagram indicating an embodiment of a system of the disclosure;
- Figure 5A depicts exemplary diagrams indicating actuator input in a first degree of freedom (rx) for a base case and various embodiments, and a related error in a second degree of freedom resulting from the base case; and
- Figure 5B depicts exemplary diagrams of a line-of-sight error resulting from the settings indicated in Figure 5A.

DETAILED DESCRIPTION

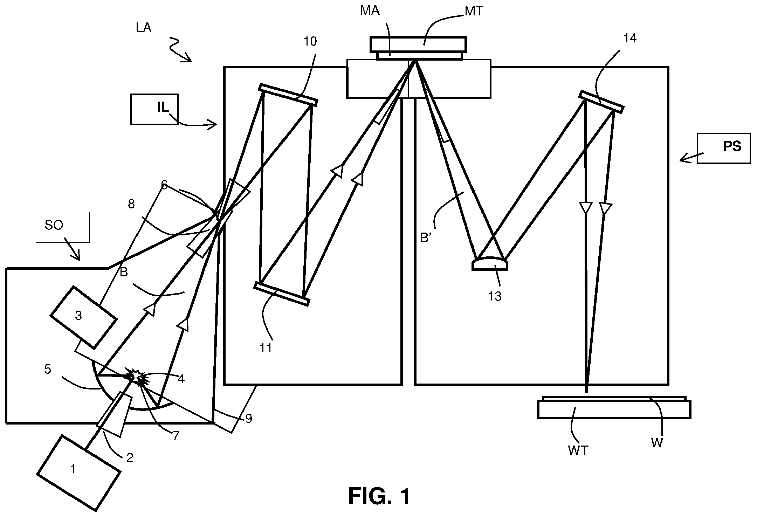

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

As referenced in the introduction with reference to Figure 2, one or more optical elements 20 may be provided with two linear actuators 22, 24 per linear degree of freedom. To achieve three dimensional control, each controllable optical element may be provided with three pairs of linear actuators. The three pairs of actuators enable linear movement (translation) of the optical element 20 along three mutually perpendicular axes x, y, and z. Herein, each actuator of a pair works in the same direction. To achieve six degrees of freedom, a respective optical element may be provided with six linear actuators, with pairs of two linear actuators for each axis.

The above provides a general description of a potential control of movement of an optical element in up to six degrees of freedom, using six linear actuators. For a "linear" motion (i.e. translation) any combination of the six actuators may be needed. In other words, the relation between the six actuator forces and six degrees of freedom (and their respective forces or torques) can be generally expressed as a full 6x6 matrix.

For mapping movements of a particular optical element 20 and the impact thereof on the projected image (expressed in a line-of-sight deviation LoS), the following indicators are used herein:

  i. $R_x$, $R_y$, $R_z$ = rotational degree of freedom (i.e. rotation of the respective optical element around the x / y / z-axis respectively);
  ii. $rR_x$, $rR_y$, $rR_z$ = setpoint for the rotational degree of freedom (i.e. setpoint for the rotation of the respective optical element around the x / y / z-axis respectively);
  iii. x, y, z = translational degree of freedom (translation of the respective optical element along the x / y / z-axis respectively);
  iv. $r_x$, $r_y$, $r_z$ = setpoint for the translational degree of freedom of the respective optical element along the x / y / z-axis respectively;
  v. $eR_x$, $eR_y$, $eR_z$ = error in the rotational degree of freedom of the respective optical element around the x / y / z-axis respectively;
  vi. $e_x$, $e_y$, $e_z$ = error in the translational degree of freedom of the respective optical element around the x / y / z-axis respectively;
  vii. $eR_y * K_{xRy}$ = correction signal of the translational degree of freedom, whereby:
  viii.

$$K_{xRy} = S_{xRy} / S_{xx};$$

  ix. $S_{xRx}$, $S_{xRy}$, $S_{xRz}$, $S_{yRx}$, $S_{yRy,}$, $S_{yRz}$ = sensitivity of the optical element in the rotational degree of freedom (explanation: The sensitivity is an indication of resulting line-of-sight impact in x-direction or y-direction of the image projected on the substrate as a result of a rotation (wanted or unwanted) around respectively the x-axis, y-axis, or z-axis of the optical element);

x. $S_{xx}$, $S_{xy}$, $S_{xz}$, $S_{yx}$, $S_{yy}$, $S_{yz}$, = sensitivity of the optical element in a translational degree of freedom (explanation: The sensitivity is an indication of resulting line-of-sight impact in x-direction or y-direction of the image projected on the substrate as a result of a translation (wanted or unwanted) along respectively the x-axis, y-axis, or z-axis of the optical element).

Please note that for the sensitivities expressed above, there are two different frames of reference. One is the three-dimensional x-y-z frame of reference related to the respective optical element (as shown in Figure 2). Another frame of reference is the dislocation of the image projected on the substrate W with respect to the substrate.

Generally referring to Figure 2, when moving in for instance the z direction, both actuators 22, 24 need to provide the same force. However, due to the mentioned actuator gain inaccuracy, $F1$ and $F2$ are not equal, and hence a disturbance torque occurs that leads to an unwanted rotation $\theta$. Since the inertia $J$ of the optical element 20 is 30 to 100x smaller than the mass $m$ of the optical element, the effective rotational disturbance is relatively large, and results in a big line-of-sight error of the image position on the substrate.

Figure 3 shows an exemplary control scheme for an optical element. The control scheme may be any suitable control scheme. Figure 3 exemplifies a closed loop control scheme with feedback 26, 28. For details about control systems, reference is made to textbooks. For instance, see CONTROL SYSTEMS, ROBOTICS, AND AUTOMATION - Vol. I - Basic Elements of Control Systems, by Ganti Prasada Rao. The control scheme in Figure 3 indicates that the control loops for rotation around the y-axis $Ry$ and translation along the x-axis $x$ both effect the line of sight LoS by their respective optical sensitivities $S_{xRy}$ and $S_{xx}$ respectively.

Please note that - for simplicity - the control scheme of Figure 3 only expresses translation as a first degree of freedom and rotation as a second degree of freedom. In practice, each optical element may be controlled in six degrees of freedom. For the respective optical element, a control scheme similar to the scheme exemplified in Figure 3 may be used for each possible combination of respective degrees of freedom of movement.

A method of the present disclosure may include the step of moving one or more optical elements in at least a first degree of freedom. The method may include determining an error of movement of the optical element in one or more degrees of freedom as a result of the movement in the first degree of freedom. These steps may be repeated for one or more other degrees of freedom. I.e. the steps may include moving the respective optical element in a respective degree of freedom and determining an error of movement of the optical element in one or more of the other degrees of freedom.

Determining an error of movement of the optical element in the second degree of freedom herein may optionally include measuring a displacement of the image projected on the substrate (either in x-direction or y-direction of the substrate) due to a respective movement of the optical element. Possibly such a measurement could be done using Tool-Induced Shift (TIS). TIS refers to the difference in overlay measurements that results when the wafer is rotated by 180° and remeasured in the same overlay measurement tool. However, in practice, reference values for the relation between movement of any optical element and the projected image, i.e. LoS, are already accurately known upon delivery of the lithographic apparatus. Said relation may typically be provided by the vendor of the apparatus, so such a measurement would probably not be needed. So, as an alternative, the LoS error can be determined indirectly, via a measurement of the actual displacement of a respective optical element (in all degrees of freedom) as a result of an instruction for a particular movement of said optical element (typically in a single degree of freedom). The latter allows to derive an error of movement of the optical element. The LoS error can be calculated based on the reference values and said error of movement of the optical element.

In practice, in an EUV lithography system having mirrors instead of lenses, this effect may be most pronounced for the first mirror M1 of the projection system PS (mirror 13 in Fig. 1). An exemplary matrix expressing the error of movement of an optical element M1 is provided in table 1 below. The matrix in table 1 indicates how a translation or rotation of optical element M1 may result in a line-of sight error in either the x-direction, y-direction or z-direction. The line-of-sight (LoS) error can be regarded as an image projection error.

| M1 | $x$ [pm] | $y$ [pm] | $Rz$ [rad] | $z$ [pm] | $Rx$ [rad] | $Ry$ [rad] |
|---|---|---|---|---|---|---|
| LoS-x [pm] | -0.5 | 0 | -0.2 | 0 | 0 | -0.5 |
| LoS-y [pm] | 0 | 0.4 | 0 | 0.2 | -0.4 | 0 |
| LoS-z [pm] | 0 | 0 | 0 | -0.1 | 0 | 0 |

Herein, the translation of the optical element (x, y, and z) can typically be expressed in picometer ([pm], i.e. $10^{-12}$ m). The rotation of the optical element (Rx, Ry, and Rz) may be expressed in radians ([rad]). Rotation may be controlled with an accuracy in the same order as the translation, i.e. on a scale of $10^{-12}$ rad. The resulting translation of the image on the substrate in x, y and z direction, or LoS-x, LoS-y and LoS-z respectively, may be expressed in pm ($10^{-12}$ m).

The method of the disclosure may include a step of selecting or filtering the displacements having the largest impact on the image displacement error. In the example in the table above, for instance, the *Ry* error, induced by motion profiles in *z* direction in combination with the mentioned actuator deviations, results in the largest contribution to LoS-x. In this filtering step, the *Ry* error is selected to be adjusted and limited to thus reduce the resulting LoS-x error.

Similar measurements may be done for one or more of the other optical elements. For instance, measurements for mirrors M2 and M3 may result in the following exemplary LoS deviations

[Table 2]:

| | *x* [pm] | *y* [pm] | *Rz* [rad] | *z* [pm] | *Rx* [rad] | *Ry* [rad] |
|---|---|---|---|---|---|---|
| **M2** | | | | | | |
| **LoS-x [pm]** | 0.1 | 0 | -0.3 | 0 | 0 | 0.1 |
| **LoS-y [pm]** | 0 | -0.4 | 0 | -0.4 | 0.1 | 0 |
| **LoS-z [pm]** | 0 | 0.04 | 0 | 0.1 | 0.1 | 0 |
| **M3** | | | | | | |
| **LoS-x [pm]** | 0.03 | 0 | -0.03 | 0 | 0 | 0.3 |
| **LoS-y [pm]** | 0 | 0.1 | 0 | 0.4 | 0.1 | 0 |
| **LoS-z [pm]** | 0 | -0.04 | 0 | 0.04 | -0.1 | 0 |

Thus, for each optical element the errors in the image projection due to movements of the respective optical element can be determined. The values in tables 1 and 2 can be regarded as values for the optical sensitivities of each respective optical element (for instance SxRx, SxRy , SxRz, SyRx , SyRy,, SyRz, Sxx , Sxy , Sxz , Syx, Syy, and Syz as introduced above). In an embodiment, said optical sensitivities are provided by a vendor of the optical element. Typically, the matrices of tables 1 and 2 above including errors of movement are provided by a vendor of the optical element. Optical sensitivities a respective optical element, relating to image projection errors due to movement errors, are thus also known.

As an alternative, the optical sensitivities may be determined by respective movement of the respective optical element and at the same time measuring the resulting translation of the projected image. Movement of the respective optical element herein means translation or rotation along the respective axes of movement and with respect to the indicates degree(s) of freedom). Thus, as an option, the line of sight error may be determined by calculating a difference between the measured translation of the projected image and an expected movement of said image. In the above, "expected" means: based on the mirror references; "measured" means: based on true motion. As mentioned above, reference values for expected movements are typically provided by the vendor of a lithographic machine. Said referenced may include factory determined values. Therefore, true motion can be derived from the optical sensitivities, to derive the position errors of one or more of the optical elements.

Please note that the sensitivities can similarly be determined for one or more, typically all, optical elements in the lithographic apparatus LA. For each degree of freedom, the respective movement(s) having the largest impact on the image projection error (or line of sight error) can be selected.

In addition, the method of the disclosure may include a comparison of image projection errors due to each optical element in the projection system individually. The individual contributions of respective optical elements are exemplified in table 3 below, for mirrors M1 to M7 in the projection system PS. Note that these values represent servo-error related contributions only.

| | M1 | M2 | M3 | M4 | M5 | M6 | M7 |
|---|---|---|---|---|---|---|---|
| **LoS-x [pm]** | 50 | 5 | 2 | 8 | 2 | 0 | 2 |
| **LoS-y [pm]** | 12 | 12 | 3 | 8 | 1 | 5 | 2 |

In addition to LoS alone, the method may include to consider the contribution of the various optical elements in a projection system. In the example in table 3 above, the first optical element M1 has the largest servo-error related contribution to line of sight in x-direction. In y-direction, mirrors M1 and M2 have the largest contribution to the LoS error.

The method may include the step of filtering the optical elements. Filtering herein means selecting the optical elements having the largest relative contribution. The largest relative contribution herein may be defined on a case by case basis. In the example provided in table 3 above, the line of sight error in y-direction may consider the first, second, and maybe fourth optical elements M1, M2 and M4. For correction of the LoS-x, only M1 may be selected.

In the example above, M1 has by far the biggest contribution to LoS-x. In a next step, actuator error for the selected optical elements may be determined. For M1, the servo errors for the 6 degrees of freedom in Justage coordinates are, for example [Table 4]:

| M1 servo error | x | y | Rz | z | Rx | Ry |
|---|---|---|---|---|---|---|
| [pm/prad] | 7 | 3 | 14 | 10 | 34 | 69 |
| $\rightarrow$ Los-x | 2 | 0 | 2 | 0 | 0 | 46 |

In the example in table 4 above, the relatively large LoS-x contribution of the first optical element M1 can be mainly explained by the Ry servo error, in combination with the large optical sensitivity of LoS-x to Ry, as seen in the second row in table 4. The large Ry servo error is mainly caused by the z profile, which according to the explanation with respect to Figure 2 above mainly creates rotational errors. Whereas the example of Table 1 may provide line of sight errors due to multiple causes, the steps provided above allow to isolate the impact of actuator errors. Also, the steps allow to focus on the most relevant actuator errors. The error of movement in respective degrees of freedom of the respective optical element can thus be derived from the rotational servo error, which is known by the controller of the actuators.

Rotational and translational degrees of freedom both contribute to line-of-sight errors according to their optical sensitivities. For example, for a typical optical element, both x and Ry displacements may result in an LoS-x error. This is illustrated in Figure 3, for a single combination of one rotational and one translational degree of freedom (DoF). The x-position, by its sensitivity $S_{xx}$, and the Ry position, by its sensitivity $S_{xRy}$, together create the line-of-sight position of the image on the wafer. The LoS error induced by the rotational direction equals $S_{xRy}e_{Ry}$.

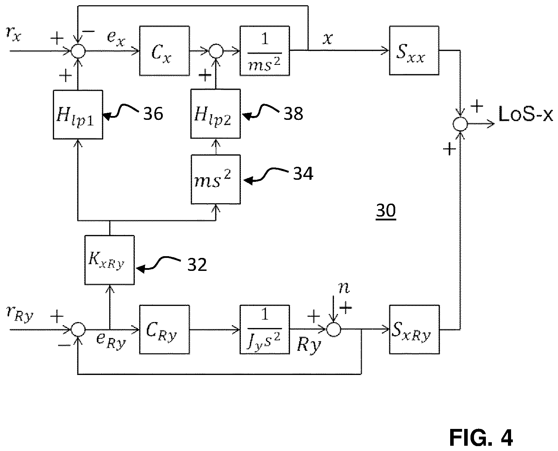

Figure 4 shows an example of a control system 30 of the present disclosure. In general, the system and method of the present disclosure create a line-of-sight (LoS) compensation due to a first DoF error of a respective optical element with movement of the same optical element in another DoF. For instance, the optical effect of rotational Ry error is corrected by movement in the x direction.

In the example of Figure 4, the compensation for instance includes adding a first compensation signal to the setpoint of the x control loop for the actuators of the respective optical element. In a practical embodiment, the first compensation factor is $(S_{xRy}/S_{xx})^*e_{Ry}$. In a practical embodiment, the compensation signal can be provided using a multiplication block 32 to multiply $e_{Ry}$ with a multiplication factor $K= (S_{xRy}/S_{xx})$. If the x controller accurately tracks this additional setpoint, it creates an image shift at wafer level which is substantially equal and opposite to the Ry-induced LoS error.

In addition to adding a setpoint using the first compensation signal, optionally a feedforward component 34 can be added as well. In an embodiment, the control system 30 may include a first low-pass filter 36 and/or a second low-pass filter 38. The first low pass filter 36 filters the signal provided from the second degree of freedom (from $e_{Ry}$ in Fig. 4) to the setpoint of the first degree of freedom (i.e. added to $r_x$ in the example of Fig. 4). The second low pass filter 38 filters the optional feedforward signal added to the control signal for the second degree of freedom at a position further in the control loop. See Figure 4 for an example.

Note that Figure 4 only shows a coupling between the control for two degrees of freedom, i.e. x and Ry. For each optical element, other combinations of DoF control may include a similar control system, linking the error of one degree of freedom to the control input of another degree of freedom. Depending on the most relevant degrees of freedom for a particular optical element, for instance determined as described herein above, the control system may additionally include, for instance:

- For LoS-x, a coupling from $r_{Ry}$ and $r_{Rz}$ towards $r_x$;
- For LoS-y, a coupling from $r_{Rx}$ and $r_{Rz}$ towards $r_y$.

So in total, with respect to a single optical element, multiple cross couplings of control of two different degrees of freedom may be relevant. Which combinations are most relevant and impactful depends on the optical sensitivities of the optical element. See tables 1 and 2 above for an example.

The above control architecture assumes that the degrees of freedom are perfectly decoupled. Decoupled herein means that, for instance, the control force in x direction does not influence Ry. If this is not true, or at least if both controls are less than 100% decoupled, the controller cannot be regarded as a pure one-way feedforward. This may compromise stability. This can be taken into account and is described in a following section.

Figure 4 indicates that if $K_{xRy} = (S_{xRy}/S_{xx})$ and the x-controller perfectly tracks $e_{Ry}$, the LoS contribution of $e_{Ry}$ becomes zero. The first and second low-pass filters $H_{lp1}$ and $H_{lp2}$ (36, 38) are used to provide some filtering of high-frequency content, which may be of particular interest for the feedforward branch. The filters 36, 38 may also create a phase lag. In addition, their impact depends on the actual high-frequency mirror behavior, and on the amount of actuator error, since the latter has an impact on the decoupling quality. Therefore, we will consider four cases:

i. No coupling (baseline);
ii. Coupling to x-setpoint only, no feedforward, no filtering;
iii. Coupling to x including feedforward, low-pass filtering for feedforward only;
iv. Coupling to x including feedforward, low-pass filtering both for reference and feedforward.

| Case | $K_{xRy}$ | $H_{lp1}$ | $H_{lp2}$ |
|---|---|---|---|
| **1 (line 50)** | 0 | - | - |
| **2 (line 52)** | $S_{xRy}/S_{xx}$ | =1 | =0 |
| **3 (line 54)** | $S_{xRy}/S_{xx}$ | =1 | 300 Hz, z=0.6 |
| **4 (line 56)** | $S_{xRy}/S_{xx}$ | 300 Hz, z=0.6 | 300 Hz, z=0.6 |

The cases exemplified in table 5 above provide examples of potential embodiments of the system of the present disclosure. Herein:

- Case 1, no coupling between the controls of two respective degrees of freedom. The expected *Ry* sensitivity function can be expressed as follows, in which *n* represents an soutput disturbance on the Ry control loop as indicated in Fig. 4:

$$LoS = LoS_{Ry} + LoS_x = LoS_{Ry} = \frac{1}{1 + P_{Ry}C_{Ry}} S_{xRy} n$$

- Case 2, $H_{lp1}$ = 1, $H_{lp2}$ = 0. In this case there is no feedforward component (34, 38) included in the system 30. The line of sight error can be expressed as the multiplication of the sensitivity functions of both loops:

$$LoS = LoS_{Ry} + LoS_x = \frac{1}{1 + P_{Ry}C_{Ry}} \cdot \frac{1}{1 + P_x C_x} S_{xRy} n$$

- Case 3. Herein, $H_{lp1}$ = 1, and $H_{lp2}$ (38) is a low-pass feedforward filter:

$$LoS = LoS_{Ry} + LoS_x = \frac{1}{1 + P_{Ry}C_{Ry}} \cdot \frac{1}{1 + P_x C_x} \left(1 - H_{lp2}\right) S_{xRy} n$$

- Case 4, $H_{lp1}$ (36) and $H_{lp2}$ (38) are the same low-pass filters $H_{lp}$:

$$LoS = LoS_{Ry} + LoS_x = \frac{1}{1 + P_{Ry}C_{Ry}} \left(1 - H_{lp}\right) S_{xRy} n$$

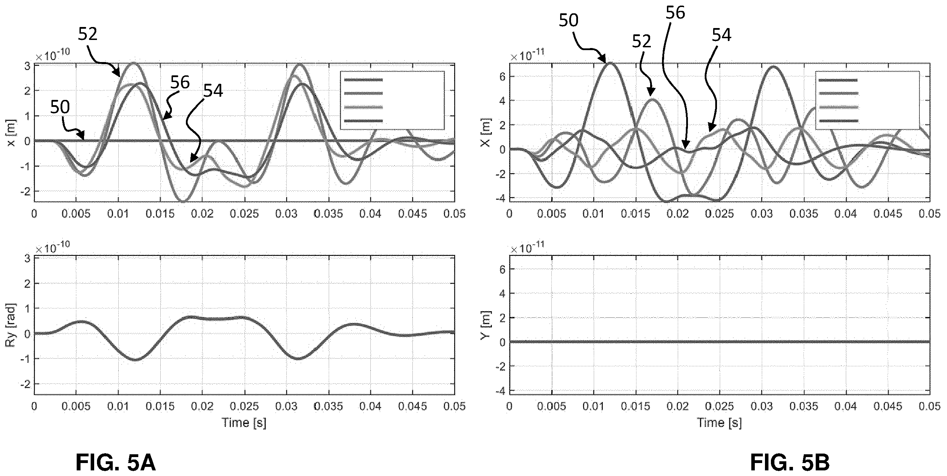

Results of tests of these four various cases are depicted in Figures 5A and 5B (lines 50, 52, 54, and 56 respectively). Herein, a step in Ry direction with a magnitude of 1 μrad, and profile parameters for standard operation, is used as a reference. The setpoint feedforward accuracy is set at 99%, resulting in a significant Ry error of about 0.1 nrad, as seen in the bottom window of Fig. 5A. When feeding this to the x controller, the top window in Fig. 5A shows that the x response starts to mimic Ry, in the end reducing the LoS impact (figure 5B). Figure 5A indicates the servo error for various cases. Figure 5B indicates the resulting impact on line of sight. In a practical embodiment, the low pass filters 36 and 38 may have a cut off frequency in the order of 300 Hz.

The four options for using filters (as exemplified in table 5) are visualized in figures 5A and 5B. Figure 5A shows the response of movement of one optical element, for instance M1, in the x-direction (top window) to an error of Ry (bottom window) of the same optical element. The response is different depending on the settings. Figure 5B shows the effect on LoS-x (top diagram) and LoS-y (lower diagram). The peak amplitude of the error (upper diagram in Fig. 5B) is largest for the case of no correction (see line 50). The second case including the feedback component via multiplier block 32 provides a significant improvement (line 52). The third case (line 54) even more so. The fourth case (line 56) provides the best results, with the most significant reduction in amplitude of the error. Thus, the LoS-x error can be reduced to various degrees by using the settings of cases 2 to 4.

The top window of Fig 5B shows LoS-x. In the exemplary case expressed herein (see table 1), LoS-x is the result of position errors mainly in the Ry and x position. LoS-x decreases depending on the filter settings, exemplified in cases 2, 3 and 4. The lower window in Figure 5B shows LoS-y. In the present example, LoS-y is not dependent on Ry or x and hence is always zero.

As indicated in Figure 5B, top diagram, the most basic version of the system of the disclosure (lines 52) may already provide a significant improvement. For instance, a reduction of the Ry error due to added movement in rx direction.

As described above, mirror 1 (for instance optical element 13 in Figure 1) may have the largest potential profit from this technique. Depending on threshold for accuracy, also other optical elements such as mirror M4 may be a candidate. In addition to the impact of rotational errors, also the magnitude of the coupling factors (such as $K_{xRy} = S_{xRy}/S_{xx}$) is taken into account. A coupling factor exceeding a predetermined threshold may mean that a large translation is created in response to a small rotational error. In itself this may impact stability. For M1 and M4, the coupling factors are, for example

[table 6] :

| Coupling | $K_{xRy}$ | $K_{xRz}$ | $K_{yRx}$ |
|---|---|---|---|
| M1 | 2.1 | 0.55 | -1.45 |
| M4 | -0.56 | -2.2 | 4.8 |

In principle, the controller design adds a single-way coupling only and hence stability is not impacted. However, if the original control loop for the optical element was not fully decoupled by itself, additional feedback terms may have arisen that could compromise stability. If so, stability can be taken into account by analyzing stability properties of all control loops under the assumption of a non-decoupled system.

The method of the disclosure may be summarized as determining a (first) correction factor or signal; and using the correction signal to correct the image position error caused by an error in a second degree of freedom by a movement in a first degree of freedom.

The method and system allow to correct a projection error or LoS error that is caused by the rotational mirror servo errors and compensate the error by translational movement, i.e. movement in other degrees of freedom of the same mirror. Herein, the method uses degrees of freedom of the respective optical element which also have an optical sensitivity in the same LoS direction. For example, this means that the LoS error induced by the *Ry* and *Rz* errors is compensated by the *x* control loop, while the *Rx* servo error is compensated by the *y* control loop. Which degrees of freedom to use to correct an error in another degree of freedom is derived from the optical sensitivities of the optical element

The method and system of the disclosure can be used, for instance, to control and correct the movement of optical elements in a projection system of a lithography machines.

State of the art EUV lithography machines include a dynamics and control architecture to limit image displacement error on the wafer in response to disturbances. The displacement error can be limited to an order of magnitude of 100 pm or smaller. The main disturbances threatening this accuracy are:

- Baseframe related (scanning) and noise related disturbances;
- Scanning mirror profiles for wafer heating correction;
- Mirror interferometer noise;
- Electromagnetic crosstalk from wafer stage or reticle stage towards the mirrors; and
- (Future) waterline acoustics due to direct mirror cooling (DCM).

The system and method of the present disclosure enable to improve the overall image placement accuracy. The method of the disclosure links, for instance, mirror rotation errors to mirror translations to reduce overall line of sight error. This technique may be referred to as "IMC" ("Intra-Mirror Control ").

The proposed solution uses characteristics of the optical element. Herein, the effect of a rotational error of the optical element on the line of sight error can be compensated by a translation of the optical element. Based on this translation, a feedthrough of the rotational error (adjusted based on the mirror sensitivities in the rotational and translational degree of freedom) to the translation controller is made.

The method and system of the present disclosure allow correction of actuator inaccuracy within the realm of a particular optical element. The method and system provide an accuracy improvement of the line-of-sight error of about a factor three compared to current state of the art methods and systems.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the examples and claims set out below.

Examples

1. A method of controlling a position of an optical element for projecting an image, the method comprising the steps of:

- providing the optical element having at least one actuator to allow movement of the optical element in at least a first degree of freedom and at least a second degree of freedom;
- determining a movement error of the optical element in at least the second degree of freedom;
- correcting an image projection error caused by the movement error in the second degree of freedom using a movement of the optical element in the first degree of freedom.

2. The method of example 1, the step of determining a movement error of the optical element comprising determining a movement error in six degrees of freedom.

3. The method of example 1 or 2, the step of determining a movement error of the optical element including obtaining said error from a controller of the number of actuators.

4. The method of any of the previous examples, comprising the step of deriving the image projection error from the movement error of the optical element.

5. The method of example 4, wherein the image projection error equals the optical sensitivities of the optical element, which are provided as a reference.

6. The method of example 4 or 5, the step of correcting the image projection error comprising providing a correction factor to the first degree of freedom, the correction factor including a multiplier based on the optical sensitivities.

7. The method of example 6, wherein the correction factor for the first degree of freedom comprises a ratio of an optical sensitivity with regard to the second degree of freedom (SDOF2) to the optical sensitivity with regards to the first degree of freedom (SDOF1).

8. The method of example 6 or 7, wherein the correction factor from the second degree of freedom to the first degree of freedom can be expressed including the multiplier $K = SDOF2 / SDOF1$.

9. The method of one of the previous examples, wherein the first degree of freedom is a translational degree freedom, and the second degree of freedom is a rotational degree of freedom.

10. The method of any of the previous examples, comprising the steps of:

- allowing the number of actuators to move the optical element in at least six degrees of freedom, comprising three translational degrees of freedom and three rotational degrees of freedom;
- controlling movement of the optical element in two or more of the at least six degrees of freedom using respective correction factors based on the optical sensitivities.

11. The method of any of the previous examples, comprising the step of using the optical element for projecting a patterned beam of radiation onto a substrate while controlling the position of the optical element.

**Claims**

1. A method of controlling a position of an optical element for projecting an image, the method comprising the steps of:

   - providing the optical element having at least one actuator to allow movement of the optical element in at least a first degree of freedom and at least a second degree of freedom;
   - determining a movement error of the optical element in at least the second degree of freedom;
   - correcting an image projection error caused by the movement error in the second degree of freedom using a movement of the optical element in the first degree of freedom.

2. The method of claim 1, the step of determining a movement error of the optical element comprising determining a movement error in six degrees of freedom.

3. The method of claim 1 or 2, the step of determining a movement error of the optical element including obtaining said error from a controller of the number of actuators.

4. The method of any of the previous claims, comprising the step of deriving the image projection error from the movement error of the optical element.

5. The method of claim 4, wherein the image projection error equals the optical sensitivities of the optical element, which are provided as a reference.

6. The method of claim 4 or 5, the step of correcting the image projection error comprising providing a correction factor to the first degree of freedom, the correction factor including a multiplier based on the optical sensitivities.

7. The method of claim 6, wherein the correction factor for the first degree of freedom comprises a ratio of an optical sensitivity with regard to the second degree of freedom ($S_{DOF2}$) to the optical sensitivity with regards to the first degree of freedom ($S_{DOF1}$).

8. System to control a position of an optical element for projecting an image, comprising:

   - at least one actuator for moving the optical element in at least a first degree of freedom and at least a second degree of freedom;
   - means to determine a movement error of the optical element in the second degree of freedom;
   - a correction mechanism to correct an image projection error caused by the movement error in the second degree of freedom using a movement of the optical element in the first degree of freedom.

9. The system of claim 8, the system comprising a controller for controlling movement of the at least one actuator, the controller being adapted to provide one or more optical sensitivities of the optical element.

10. The system of claim 8 or 9, the correction mechanism being adapted to correct the image projection error by providing a correction factor to the first degree of freedom, the correction factor including a multiplier based on the projection sensitivities.

11. The system of claim 10, wherein the correction factor for the first degree of freedom comprises a ratio of an optical sensitivity with regard to the second degree of freedom ($S_{DOF2}$) to the optical sensitivity with regard to the first degree of freedom ($S_{DOF1}$).

12. The system of any of claims 8 to 11, wherein:

   - the at least one actuator is adapted to move the optical element in at least six degrees of freedom, comprising three translational degrees of freedom and three rotational degrees of freedom;

- the controller being adapted for controlling movement of the optical element in two or more of the at least six degrees of freedom using respective correction factors based on the projection sensitivities.

13. A lithographic system comprising:

- at least one radiation source for providing radiation;
- at least one substrate table for holding a substrate;
- at least one optical element for directing the radiation towards the substrate; and
- a control system adapted to control a position of the at least one optical element, the control system being adapted to correct an image projection error caused by a movement error in a second degree of freedom using a movement of the optical element in the first degree of freedom.

14. The lithographic system of claim 13, comprising at least one system according to one of claims 8 to 12.

15. System to control a position of an element for semiconductor manufacturing process, comprising:

- at least one actuator for moving the element in at least a first degree of freedom and at least a second degree of freedom;
- means to determine a movement error of the element in the second degree of freedom;
- a correction mechanism to correct an image projection error caused by the movement error in the second degree of freedom using a movement of the element in the first degree of freedom.

FIG. 1

**FIG. 2**

**FIG. 3**

**FIG. 4**

FIG. 5A

FIG. 5B

EP 4 455 785 A1

Europäisches
Patentamt

European
Patent Office

Office européen
des brevets

# EUROPEAN SEARCH REPORT

**Application Number**

**EP 23 16 9762**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/094705 A1 (KUGLER JENS [DE] ET AL) 28 March 2019 (2019-03-28) * paragraphs [0007], [0055] – [0060] * ----- | 1-15 | INV. G03F7/00 G02B7/182 |
| A | US 2014/016108 A1 (FREIMANN ROLF [DE] ET AL) 16 January 2014 (2014-01-16) * paragraphs [0019], [0048] – [0060] * ----- | 1-15 | |
| A,D | US 2021/026252 A1 (TREUBEL FRANK [DE] ET AL) 28 January 2021 (2021-01-28) * paragraphs [0011] – [0023] * ----- | 1-15 | |

| | |
|---|---|
| | **TECHNICAL FIELDS SEARCHED (IPC)** |
| | G03F G02B |

The present search report has been drawn up for all claims

| Place of search | Date of completion of the search | Examiner |
|---|---|---|
| Munich | 12 October 2023 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 9762

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2023

| Patent document cited in search report | | Publication date | Patent family member(s) | | Publication date |
|---|---|---|---|---|---|
| US 2019094705 | A1 | 28-03-2019 | US | 2019094705 A1 | 28-03-2019 |
| | | | WO | 2017207016 A1 | 07-12-2017 |
| US 2014016108 | A1 | 16-01-2014 | DE | 102008030664 A1 | 21-01-2010 |
| | | | JP | 5452591 B2 | 26-03-2014 |
| | | | JP | 5897540 B2 | 30-03-2016 |
| | | | JP | 6622116 B2 | 18-12-2019 |
| | | | JP | 2011526735 A | 13-10-2011 |
| | | | JP | 2014096601 A | 22-05-2014 |
| | | | JP | 2016145985 A | 12-08-2016 |
| | | | US | 2011164232 A1 | 07-07-2011 |
| | | | US | 2014016108 A1 | 16-01-2014 |
| | | | US | 2016246182 A1 | 25-08-2016 |
| | | | WO | 2010000757 A1 | 07-01-2010 |
| US 2021026252 | A1 | 28-01-2021 | CN | 112005171 A | 27-11-2020 |
| | | | DE | 102018205714 A1 | 17-10-2019 |
| | | | EP | 3781988 A1 | 24-02-2021 |
| | | | KR | 20200143423 A | 23-12-2020 |
| | | | TW | 201944178 A | 16-11-2019 |
| | | | US | 2021026252 A1 | 28-01-2021 |
| | | | WO | 2019201843 A1 | 24-10-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20210026252 A1

**Non-patent literature cited in the description**

- **GANTI PRASADA RAO.** CONTROL SYSTEMS, ROBOTICS, AND AUTOMATION. *Basic Elements of Control Systems,* vol. I